(19) Europäisches Patentamt
European Patent Office
Office européen des brevets

(11) EP 0 852 729 B1

(12) FASCICULE DE BREVET EUROPEEN

(45) Date de publication et mention de la délivrance du brevet:
**23.05.2001 Bulletin 2001/21**

(21) Numéro de dépôt: **96932643.8**

(22) Date de dépôt: **24.09.1996**

(51) Int Cl.7: **G01R 29/10**

(86) Numéro de dépôt international:
**PCT/FR96/01490**

(87) Numéro de publication internationale:
**WO 97/12253 (03.04.1997 Gazette 1997/15)**

(54) **PROCEDE DE MESURE DU DIAGRAMME D'UNE ANTENNE**

VERFAHREN ZUR MESSUNG DES DIAGRAMMES EINER ANTENNE

ANTENNA PATTERN MEASUREMENT METHOD

(84) Etats contractants désignés:
**DE ES FR GB IT NL**

(30) Priorité: **26.09.1995 FR 9511256**

(43) Date de publication de la demande:
**15.07.1998 Bulletin 1998/29**

(73) Titulaire: **CENTRE NATIONAL D'ETUDES SPATIALES**
**F-75039 Paris Cedex 01 (FR)**

(72) Inventeur: **ISSLER, Jean-Luc**
**F-31400 Toulouse (FR)**

(74) Mandataire: **Des Termes, Monique et al**
**Société Brevatome**
**3, rue du Docteur Lancereaux**
**75008 Paris (FR)**

(56) Documents cités:
**FR-A- 2 655 427**

- **IEEE ANTENNAS AND PROPAGATION SOCIETY INT. SYMP., vol. 4, 20 - 24 Juillet 1992, CHOCAGO,US, pages 2060-2063, XP000340085 EKELMAN ET AL.: "on-site station antenna verification"**
- **IEE PROC. A, vol. 127, no. 7, Septembre 1980, STEVENAGE, pages 417-433, XP002005327 KEEN : "satellite-antenna measurement techniques"**
- **IEEE 1988 INT. SYMP. ON ELECTROMAGNETIC COMPATIBILITY, 2 Août 1988, SEATTLE,US, pages 290-294, XP000015319 DEMARINIS: "quality control of antenna calibration"**
- **LECTRONICS AND COMMUNICATIONS IN JAPAN, PART I, vol. 70, no. 8, Août 1987, NEW YORK,US, pages 119-126, XP000159280 KONDOU: "radiation characteristics of reflector antenna"**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

EP 0 852 729 B1

## Description

Domaine technique

La présente invention concerne un procédé de mesure du diagramme d'une antenne.

Etat de la technique antérieure

La caractérisation d'antennes par des méthodes de mesure s'avère nécessaire :

- pour dimensionner par des études expérimentales des antennes non modélisables ;
- pour mettre au point les antennes dont la conception a été dégrossie par des modèles "approchés" ;
- pour valider les résultats de modélisation obtenus avec des logiciels "exacts", et l'utilisation de ces modèles lorsqu'on a un doute sur le sens physique de certains résultats de calcul.

L'objectif des moyens de mesure est de relever les caractéristiques de rayonnement et d'adaptation des antennes :

- en reproduisant au mieux les conditions d'utilisation dans lesquelles elles fonctionnent (par exemple ondes planes en réception) par l'utilisation de bases extérieures longues (champ lointain) ou de bases compactes (onde plane recréée à courte distance dans une chambre anéchoïque) ;
- par des relevés précis du champ proche (amplitude et phase) sur une surface entourant l'antenne et par calcul du champ lointain rayonné ;
- par des mesures d'impédance (adaptation de l'antenne) qui sont obtenues à l'aide d'un analyseur de réseau vectoriel, de préférence en chambre anéchoïque ou en espace libre pour éviter tout couplage de l'antenne avec le laboratoire de mesure.

Dans une base de mesure en champ lointain telle que représentée sur la figure 1, l'antenne à mesurer 10 est placée dans une direction déterminée par rapport à une antenne émettrice 11 parfaitement étalonnée en gain et en puissance émise. L'antenne à mesurer, qui peut être protégée par un radôme, est connectée à un appareil 12 mesurant par exemple la puissance et la phase du signal reçu. La distance D entre les deux antennes doit être suffisante pour que les ondes reçues par l'antenne à mesurer soient des ondes planes Un positionneur 13 permet d'orienter l'antenne à mesurer 10 dans différentes directions, par exemple en rotation $\varphi$ et en direction de visée $\theta$. L'inconvénient d'une telle base de mesure est qu'elle nécessite un grand terrain dont la taille dépend de la longueur d'onde. La longueur de ce terrain peut atteindre quelques centaines de mètres.

Dans une base compacte telle que représentée sur la figure 2, qui peut être située dans un bâtiment, les ondes émises par une antenne 21 d'émission en ondes hémisphériques sont réfléchies par un réflecteur 22 qui transforme les ondes sphériques en ondes planes qui sont reçues par l'antenne à mesurer 23, ce qui permet de diminuer l'effet technique dû à la distance. L'inconvénient d'une telle base est qu'elle utilise des moyens précis mais chers, présentant de pics des difficultés de mise au point.

Dans une base champ proche, telle que représentée sur la figure 3, on mesure la puissance et la phase du signal en champ proche émis par une source 24, et on applique finement la théorie des antennes, ce qui permet d'obtenir les caractéristiques de l'antenne à mesurer 25, grâce à un appareil de mesure 26. L'inconvénient d'une telle base est de nécessiter des sondes de mesure très précises et très exactes et des moyens de calculs sophistiqués.

Dans le domaine spatial, le secteur qui concerne la localisation/navigation par satellite connaît un développement important. Actuellement un système mondial de positionnement utilisant un grand nombre de satellites est le système américain G.P.S. (Global Positioning System) qui permet à un navigateur de déterminer sa position et sa vitesse. Un système équivalent GLONASS a été développé par l'URSS.

D'autres constellations de satellites de télécommunication avec les mobiles terrestres et/ou de navigation devraient être lancées dans l'avenir, comme par exemple :

- GLOBALSTAR fonctionnant avec une liaison descendante en bande S ;
- IRIDIUM fonctionnant en bande S ;
- ORBCOMM fonctionnant en VHF ;
- STARSYS fonctionnant en VHF ;
- GNSS2 fonctionnant en bande L.

Les références [1] et [2] décrivent des méthodes de mesure de l'attitude d'un satellite en utilisant une antenne

GPS.

La référence [3] décrit l'utilisation du rapport signal/bruit pour la correction d'erreur due aux trajets multiples dans des mesures de phase différentielle (ou interférométrique) GPS.

La référence [4] étudie l'utilisation de récepteurs GPS et de récepteurs GPS/GLONASS. Cet article illustre le fait que de tels récepteurs sont à présent couramment employés.

Les références [5] et [6] donnent la description technique et les caractéristiques du système global de navigation par satellite GLONASS-M.

La référence [8] donne un aperçu de différents types de systèmes d'antennes utilisés sur satellites. Cet article décrit notamment une chambre anéchoique semi-ouverte pour satellite, faisant partie d'une base de mesure d'antenne en champ lointain. Elle décrit également l'utilisation d'un mât à l'extrémité duquel est disposée une antenne à mesurer, d'un récepteur des signaux en provenance de cette antenne et d'un moyen de traitement des signaux en sortie de ce récepteur.

La référence [9] décrit un système de vérification d'antenne sur site qui utilise un ordinateur pour contrôler l'équipement de mesure micro-onde, en réalisant une réduction de données, et en fournissant immédiatement les résultats. Elle décrit un procédé de mesure du diagramme de cette antenne dans lequel :

- on connecte l'antenne à un récepteur ;
- on place l'antenne orientée dans la direction du ciel ;
- on enregistre les données reçues ;
- on déduit par calcul le diagramme de ladite antenne.

L'ordinateur permet de réaliser des mesures automatisées et un traitement adéquat. Cette référence décrit un système de mesure du diagramme d'une antenne émettant un signal vers un satellite coopératif répétant ledit signal vers une autre antenne de réception au sol, également coopérative. Ceci nécessite donc :

- un moyen spécifique de transmission (comme dans le cas des moyens classiques de mesure de diagramme d'antenne) ;
- la maîtrise du répéteur du satellite utilisé et de l'antenne de réception supplémentaire.

L'objet de l'invention est de permettre la mesure de diagramme d'antennes, sans nécessiter la mise en oeuvre de moyens de mesure lourds, grâce aux satellites d'une constellation donnée.

Exposé de l'invention

La présente invention propose un procédé de mesure du diagramme d'une antenne dans lequel :

- On connecte l'antenne à un récepteur capable de fournir des mesures de C/No, qui est le rapport de la puissance de signal utile sur la densité spectrale de puissance de bruit et éventuellement des mesures de variation de phase.

- On place l'antenne au sommet d'un mât, ou d'un satellite porteur, orientée dans la direction du ciel pour suivre les satellites d'une constellation, la bande de réception de l'antenne contenant la bande d'émission des antennes des satellites.

- On enregistre les rapports C/No associés aux satellites observables et éventuellement les variations de phase pendant une durée déterminée de façon automatique.

- On en déduit par calcul le diagramme de ladite antenne.

Avantageusement on calcule une fonction de gain de l'antenne déterminée par un nombre limité de coefficients. Ces coefficients sont ajustés à l'aide des mesures selon un critère des moindres carrés.

A titre d'exemple, le gain de l'antenne s'exprime comme une série limitée de fonctions élémentaires fi de $\theta$ et de $\varphi$ paramétrées par les coefficients ai, bi, ci, di et ei :

$$G_r = \sum_{i=0}^{i=n} f_i\left(ai, bi, ci, di, ei, \theta, \varphi\right)$$

$\theta$ et $\varphi$ étant des coordonnées sphériques ; ai, bi, ci, di et ei étant des coefficients.

L'antenne peut être une antenne en bande L, S, C, VHF ou UHF, par exemple.

La constellation de satellites peut être du type GPS, GLONASS, GNSS2, GLOBALSTAR, IRIDIUM, ORBCOMM, STARSYS, SATIVOD, ou TELEDESIC par exemple.

Avantageusement l'antenne est disposée sous un radôme dans le cas où une protection contre le milieu extérieur est indispensable à tout moment. Ceci est notamment le cas si l'antenne à mesurer est déjà montée sur un satellite ou une autre structure porteuse sensible. Un préamplificateur calibré en facteur de bruit est disposé entre l'antenne et le récepteur. L'antenne peut être disposée sur un positionneur en azimut et en site.

Le procédé de l'invention présente de nombreux avantages :

- il ne nécessite plus de moyen d'émission spécifique ;
- il permet d'utiliser des récepteurs du commerce, à faible coût, comme les récepteurs GPS, GLONASS, GPS-GLONASS ;
- on ne mesure plus nécessairement la puissance et la phase du signal, ce qui nécessitait une mesure des pertes de polarisation, mais on mesure le rapport C/No qui intègre toutes les pertes qui se produisent le long du trajet. On effectue donc une mesure globale ;
- on peut mesurer le diagramme d'une antenne de réception de signaux GPS, GLONASS (ou provenant d'autres constellations) montée sur un satellite déjà placé en orbite.

Les moyens matériels à mettre en oeuvre sont beaucoup moins lourds et chers que dans le cas des bases classiques de mesure d'antennes (base champ lointain, base longue, base champ proche, base compacte).

Les antennes à mesurer qui ne sont pas spécifiquement dédiées à la réception d'une constellation de satellites doivent être à relativement large bande.

## Brève description des dessins

- Les figures 1 à 3- illustrent différents dispositifs de l'art antérieur ;
- les figures 4 et 5 illustrent le dispositif de l'invention ;
- la figure 6 illustre la courbe du gain de l'antenne à mesurer par rapport à des coordonnées sphériques ;
- la figure 7 illustre l'ensemble des traces des satellites GPS pendant une durée de 24 heures ;
- les figures 8 et 9 illustrent un exemple de passage d'un satellite et la courbe de mesure de C/No correspondante .
- la figure 10 présente des courbes de mesure de C/No réelles correspondant au passage de plusieurs satellites GPS ;
- les figures 11 et 12 illustrent une caractéristique de deux variantes de réalisation du dispositif de l'invention.

## Exposé détaillé de modes de réalisation

L'invention permet la mesure de diagramme d'antennes, par exemple en bande L, grâce aux satellites d'une constellation, et aux récepteurs associés.

Les constellations de satellites utilisables sont par exemple de type :

- GPS ;
- GLONASS.

Les bandes de fréquence utilisables sont alors:

pour GPS : L1 $\rightarrow$ autour de 1575,42 MHz
L2 $\rightarrow$ autour de 1227,60 MHz
pour GLONASS : Différentes fréquences L1 et L2 sont possibles

Comme représenté sur les figures 4 et 5, l'invention consiste à placer l'antenne à mesurer vers le ciel, en direction des différents satellites 31 d'une constellation. Elle est disposée au sommet d'un mât 32 (ou autre support) situé dans un lieu où l'on minimise les réflexions parasites (absence de bâtiments ou d'obstacles à proximité, revêtement absorbant sur le sol autour du mât). L'antenne à mesurer est connectée à un récepteur 33 par exemple de type GPS ou GLONASS ou GPS-GLONASS (GNSS), éventuellement par l'intermédiaire d'un préamplificateur 36, qui peut être intégré dans l'antenne.

Le mât 32 est dimensionné pour pouvoir supporter l'antenne 30. Cette antenne 30 peut être de différents types. Ce peut être par exemple une hélice, une parabole. Elle peut être située sous un radôme de protection.

La hauteur du mât doit être de quelques longueurs d'onde. Dans un exemple de réalisation la hauteur de ce mât est de un mètre environ. Il permet ainsi de surélever l'antenne par rapport aux surfaces les plus proches.

Ce mât doit être réalisé en un matériau non métallique, diélectrique, par exemple en Téflon (marque déposée).

Les structures d'absorbant 34 disposées sur et autour de ce mât peuvent être des mousses qui contiennent des particules de carbone pour absorber le signaux radioélectriques (fabriqués par exemple par la société Emerson et Cumming).

Le récepteur est connecté à un calculateur 35, qui enregistre différentes données fournies par l'équipement :

- les éphémérides de chacun des satellites poursuivis (option) ;
- les mesures de rapport C/No faites pour chacun des satellites poursuivis ;
- les mesures de variation de la phase des porteuses des signaux reçus (option).

Dans le cas où le récepteur ne pourrait pas acquérir les éphémérides des satellites poursuivis, on suppose que celles-ci sont obtenues par le calculateur 35, relié à une base de données contenant ces informations.

On définit le gain Gr de l'antenne à mesurer en fonction de deux angles : θ et φ (coordonnées sphériques). On obtient la représentation de Gr illustrée à la figure 6.

On peut faire l'hypothèse que le gain de l'antenne à tester s'exprime comme une série limitée de fonctions élémentaires fi de θ et φ paramétrées par les coefficients ai, bi, ci, di et ei.

$$G_r = \sum_{i=0}^{i=n} f_i(ai,\ bi,\ ci,\ di,\ ei,\ \theta,\ \varphi)$$

La fonction de gain $G_r$ est alors caractérisée par (n + 1) x 5 coefficients, dans le cadre de cet exemple.

La détermination du gain de l'antenne consiste à estimer les coefficients ai, bi ci,di et ei à l'aide des mesures de rapport C/No et de la connaissance des angles θ et φ représentant les directions de visée des satellites poursuivis, le rapport C/No étant le rapport puissance de signal utile sur densité spectrale de puissance de bruit.

Cette connaissance des angles θ et φ est obtenue grâce aux éphémérides :

φ = élévation = fonction (position du mât, éphémérides)
θ = azimut = fonction (position du mât, éphémérides).

On obtient l'équation du bilan de liaison, C/No étant un rapport mesuré par le récepteur

$$\left(\frac{C}{No}\right) = G_{ej}(\theta,\varphi) \times P_{ej} \times \frac{c^2}{(4\pi)^2 \times D_j^2 \times f_0^2} \times \frac{1}{L_{(\theta,\varphi)}} \times G_r(\theta,\varphi) \times \frac{1}{No}$$

avec :

j = n° du satellite poursuivi
$P_{ej}$ = puissance émise par le satellite n°j
$G_{ej}$ = gain de l'antenne d'émission du satellite n° j
$D_j$ = distance entre l'antenne à tester et le satellite n° j
c = vitesse de la lumière
$f_0$ = fréquence de travail pour la mesure de gain Gr
$L_{(\theta,\varphi)}$= pertes diverses (polarisation, atmosphère, pluie...) avec : $L_{(\theta,\varphi)}$ >0.

$$No = k.T \text{ avec } T = \frac{T_{ANT}}{L_{FRX}} + \left(1 - \frac{1}{I_{FRX}}\right) x T_{FRX} + T_R$$

| | |
|---|---|
| k : | constante de Boltzmann |
| T : | température équivalente de bruit |
| $T_{ANT}$ : | température de bruit de l'antenne |
| $L_{FRX}$ : | pertes de la ligne d'alimentation (feeder) |
| $T_{FRX}$ : | température de la ligne d'alimentation (feeder) |
| $T_R$ : | température de bruit du récepteur |
| $T_{ANT}$,$L_{FRX}$,$T_{FRX}$ et $T_R$ | sont supposés connus. |

Lorsque θ et φ sont connus (grâce aux éphémérides), on connaît : $G_{ek}$,$D_k$,L ; par ailleurs, *f* est connue.
Les inconnues sont donc $P_{ek}$ et les ai, bi, ci,di et ei.
Dans le cas d'une constellation à 24 satellites, K = 1, 2,...., 23, 24.
Les inconnues sont donc :

$P_{e1}$, $P_{e2}$,..... $P_{e24}$
et : $a_1$, $a_2$, ..... , $a_n$
$b_1$, $b_2$,....., $b_n$
$c_1$, $c_2$,....., $c_n$
$d_1$, $d_2$,....., $d_n$
$e_1$, $e_2$,....., $e_n$

Les inconnues représentent donc le vecteur d'état du filtre d'estimation du gain.
Le procédé d'estimation du gain sera un processus d'optimisation ayant donc pour modèle le bilan de liaison, utilisant éventuellement l'une des contraintes suivantes, citées à titre d'exemple :

* Contrainte de continuité :

$$G_r(\theta,\varphi)-G_r(\theta+\Delta\theta,\varphi+\Delta\varphi)\leq\Delta G_r(\Delta\theta,\ \Delta\varphi)$$

Δθ et Δφ : valeurs d'écart angulaire
$\Delta G_r$ : écart de gain maximal tolérable, pour les écarts angulaires Δθ et Δφ.

* Contrainte de symétrie de révolution :

$$G_r(\theta_1,\varphi)= G_r(\theta_2,\varphi)$$

pour des valeurs quelconques de $\theta_1$, $\theta_2$ et $\varphi_0$.

* Contrainte de gain positif :
  $G_r(\theta,\varphi) > 0$ pour des valeurs quelconques de θ et φ.

Le procédé de l'invention consiste donc à enregistrer les mesures de C/No pendant une longue durée par exemple pendant plusieurs jours, de façon automatique, à 1 'aide d'un récepteur et d'un moyen de traitement associé par exemple un calculateur.
En 24 heures, les passages de satellites de la constellation utilisée ont l'allure représentée sur la figure 7. On remarque que les traces des satellites poursuivis sont assez bien réparties dans l'ensemble des valeurs possibles pour θ et φ. Toutefois, cette répartition n'est pas parfaite. En effet, pour une position de l'antenne donnée, certains domaines de variation de θ et φ ne seront jamais atteints par les satellites de la constellation utilisée, du fait de la géométrie de leurs orbites.
Pour un exemple de passage de satellite représenté sur la figure 8, on a la courbe de C/No correspondant représentée sur la figure 9.
La durée d'une trace complète, telle que représentée sur la figure 9, est en général de quelques heures (durée d'un passage de satellite de radionavigation).
Sur la figure 10 on a des courbes de mesure de C/No réelles correspondant au passage de plusieurs satellites GPS.
Le rythme des mesures de C/No est programmable, par le récepteur choisi.
Le logiciel d'estimation du gain peut être typiquement un optimisateur de type moindre carré, dont le critère

et les contraintes sont donnés en annexe.

Les valeurs estimées pour les ai, bi, ci, di, ei et $P_{eK}$ sont celles qui minimisent l'énergie des résidus, au sens des moindres carrés.

Dans une variante de réalisation les constellations de satellites GPS et GLONASS sont dimensionnées de telle sorte que l'on retrouve toujours le même satellite au même "endroit" $(\theta,\varphi)$ dans le ciel à la même heure du jour, à quelques minutes près.

On peut donc imaginer l'utilisation d'un positionneur de l'art connu en azimut et éventuellement en site :

- en azimut : le plateau horizontal 40 sur laquelle l'antenne à tester peut tourner d'un angle parfaitement connu $\theta_0$, programmable, comme représenté sur la figure 11 ;
- en site (élévation) : le plateau 40 peut s'incliner d'un angle $\varphi_0$ programmable et parfaitement connu, comme représenté sur la figure 12.

Les rotations de ce plateau 40 de montage de l'antenne à mesurer permettent d'éviter d'attendre trop longtemps avant de constater un changement significatif de la configuration des passages des satellites dans le repère lié à l'antenne. De plus, ceci permet de minimiser l'absence de mesures de C/No pour certains domaines de variation de $\theta$ et $\varphi$, du fait de la géométrie des orbites des satellites de la constellation utilisée.

Dans une variante de l'invention, l'antenne à mesurer reçoit des signaux provenant de satellites géostationnaires, dont on connaît la position orbitale, la fréquence et le gain d'émission. Les bandes de réception utilisables peuvent être par exemple : VHF, UHF, C, L, S, Ku.

Le principe de mesure décrit reste donc applicable dans ce cas, si l'on dispose du positionneur décrit précédemment.

Dans une autre variante de l'invention, on peut mesurer le diagramme d'une antenne de réception de signaux provenant de constellations, montée sur un satellite en orbite dont on connaît en permanence l'attitude pour les trois axes.

En effet, la connaissance de cette attitude permet de déterminer l'orientation du repère de l'antenne à mesurer par rapport aux directions d'observations des satellites de la constellation utilisée.

Le problème de la mesure du diagramme d'antenne se ramène donc aux cas précédents. Dans ce cas, l'antenne à mesurer est connectée à un récepteur de constellation embarqué sur le satellite porteur.

Les récepteurs de signaux de constellation actuellement disponibles permettent également d'observer finement les variations de la phase des porteuses reçues (après désétalement de spectre, dans le cas de l'utilisation de signaux transmis en spectre étalé).

Or, la phase du signal reçu fait un saut de $\pi$ (3,14159... radians), lorsque la direction d'observabilité d'un satellite poursuivi passe du lobe principal du diagramme de l'antenne à l'un des lobes secondaires dudit diagramme.

L'ensemble des couples $(\theta_0,\varphi_0)$ associés à un changement de phase de $\pi$ constitue donc la frontière entre le lobe principal et les lobes secondaires de l'antenne. La connaissance de cette frontière, en complément des mesures de rapport C/No, permet d'affiner l'estimation du diagramme de l'antenne à mesurer.

On estimera l'équation de cette frontière H à l'aide des mesures des couples $(\theta_0,\varphi_0)$ associés au changement de phase, en utilisant un critère de moindres carrés.

Cette équation est notée :

$$H(\theta_0,\varphi_0) = 0$$

L'estimation de l'équation de la frontière est notée :

$$\hat{H}(\theta_0,\varphi_0) = 0$$

La fonction de gain de l'antenne à mesurer est supposée nulle pour toutes les valeurs de $\theta_0$ et $\varphi_0$ vérifiant cette équation.

ANNEXE

Notations utiles

| | |
|---|---|
| j = | numéro du satellite de constellation observé, compris entre 1 et J |
| n = | numéro d'ordre chronologique d'une mesure faite par le récepteur de constellation |
| $N_j$ min = | numéro d'ordre de la première mesure faite à l'aide du satellite n° j |
| $N_{j\,max}$ = | numéro d'ordre de la dernière mesure faite à l'aide du satellite n° j |
| $\left(\frac{C}{No}\right)_{j,n}$ = | mesure du rapport C/No faite à l'instant n, à l'aide du satellite n° j |
| k = | constante de Boltzmann = $1{,}379.10^{-23}$ W/K.Hz |
| L = | pertes totales (hors pertes d'espace libre) jusqu'à l'entrée des circuits de traitement du signal du récepteur de constellation |
| T = | température système de bruit du récepteur connecté à l'antenne |
| $f_L$ = | fréquence du signal utilisé, diffusé par la constellation |
| c = | vitesse de la lumière = $3.10^8$ m/s |
| $D_{j,n}$ = | distance entre l'antenne et le satellite n°j, à l'instant n |
| $PIRE_j$ = | puissance intrinsèque rayonnée équivalente du satellite n° j |
| $\widehat{PIRE}_j$ = | estimation de la puissance intrinsèque rayonnée équivalente du satellite n° j |
| $PIRE_{min}$ = | PIRE minimum possible pour un satellite de la constellation |
| $PIRE_{max}$ = | PIRE maximum possible pour un satellite de la constellation |
| $\varphi_{j,n}$ = | angle de visée du satellite n°j, à l'instant n, par rapport à l'axe principal du diagramme d'antenne |
| $\varphi_{max}$ = | angle $\varphi_{j,n}$ maximum considéré |
| $\theta_{j,n}$ = | angle de la direction de visée dans le plan de l'antenne (défini par les axes x et y) du satellite n° j, à l'instant n, par rapport à l'axe x |
| Gr (θ, φ) = | fonction de gain de l'antenne de réception, définie dans le repère x,y,z |
| $\hat{G}r$ (θ,φ) = | estimation de la fonction de gain de l'antenne |
| i = | ordre des coefficients de la fonction de gain de l'antenne |
| I = | ordre maximum des coefficients de la fonction de gain |
| f = | fonction de base de la fonction de gain de l'antenne |
| ai, bi, ci, di, ei = | coefficients d'ordre i de la fonction de gain |
| $\widehat{ai}$, $\widehat{bi}$, $\widehat{ci}$, $\widehat{di}$, $\widehat{ei}$ = | coefficients d'ordre i estimés de la fonction de gain |

A = vecteur des inconnues recherchées lors de la détermination du gain d'antenne et des PIREs

Â = vecteur solution contenant les paramètres de la fonction de gain et des PIREs

$M_{j,n}$ = valeur de la fonction de mesure

$F(A;\theta_{j,n} ; \varphi_{j,n})$ = fonction de gain x PIRE

**Equations utiles**

*Bilan de liaison*

$$PIRE_j = P_{ej} \times Ge_j$$

$$\left(\frac{C}{No}\right)_{j,n} = PIRE_j \times \frac{c^2}{(4\pi)^2 . D_{j,n}^2 . f_L^2} \times \hat{G}r(\theta_{j,n} ; \varphi_{j,n}) \times \frac{1}{k.T.L}$$

*Fonction de gain*

$A = [PIRE_1,...,PIRE_j,ao,...,ai,bo,...bi,co,...,ci,do, ...,di, eo,..., ei]$

$$\hat{A} = [\widehat{PIRE}_1,...,\widehat{PIRE}_j,\widehat{ao}...,\widehat{ai},\widehat{bo},...\widehat{bi},\widehat{co},...,\widehat{ci},\widehat{do},...,\widehat{di},\widehat{eo},...,\widehat{ei}]$$

$$Gr(\theta,\varphi) = \sum_{i=0}^{i=1} f(ai; bi; ci; di; ei; \theta; \varphi)$$

$$\hat{G}r(\theta,\varphi) = \sum_{i=0}^{i=1} f(\hat{a}i; \hat{b}i; \hat{c}i; \hat{d}i; \hat{e}i; \theta; \varphi)$$

par exemple :

$$Gr(\theta,\varphi) = \sum_{i=0}^{i=1} ai \cos(bi\,\theta + ci)\cos(di.\varphi + ei)$$

(la symétrie de révolution est imposée en choisissant : bi = 0) <u>ou</u> :

$$G_r(\theta,\varphi) = \sum_{i=0}^{i=1} a_i \varphi^i,$$

(symétrie de révolution imposée, dans ce cas) ou :

$$Gr(\theta,\varphi) = \sum_{i=0}^{i=1} ai\left[\cos(\varphi + bi)\right]^{ci}$$

La fonction de gain peut également être décomposée en fonctions de Bessel.

*Détermination de la fonction de gain*

$$M_{j,n} = \left(\frac{C}{No}\right)_{jn,} \times k.T.L.f_L^2 \times \frac{(4\pi)^2 \times D_{j,n}^2}{c^2}$$

$$F(A;\ \theta_{j,n};\ \varphi_{j,n}) = Gr(\theta_{j,n},\ \varphi_{j,n}) \times PIRE_j$$

*Critère des moindres carrés*

Â = A tel que la somme du carré des résidus

$$\left[\sum_{j=1}^{j=J} \sum_{n=Njmin}^{n=Njmax} \left\{M_{j,n} - F(A\ ;\ \theta_{j,n}\ ;\ \varphi_{j,n})\right\}^2\right]$$

soit minimum

*Contraintes*

* $PIRE_J \in [PIRE_{min}, PIRE_{max}]$
* $\varphi_{j,n} \in [0,\ \theta_{max}]$
* $\theta_{j,n} \in [0, 2\pi]$
* $Gr(\theta,\varphi) - Gr(\theta+\Delta\theta, \varphi+\Delta\varphi) \leq \Delta Gr(\Delta\theta, \Delta\varphi)$ (contrainte de continuité)

  $\Delta\theta$ et $\Delta\varphi$ : valeurs d'écart angulaire
  $\Delta Gr$ : écart de gain maximal tolérable, pour les écarts angulaires $\Delta\theta$ et $\Delta\varphi$.

* $Gr(\theta_1,\varphi) = Gr(\theta_2,\varphi)$ (contrainte de symétrie de révolution, en option) quelles que soient $\theta_1$, $\theta_2$ et $\varphi$.

* $\hat{G}r(\theta_0, \varphi_0) = 0$, pour $(\theta_0, \varphi_0)$ vérifiant l'équation $\hat{H}(\theta_0, \varphi_0) = 0$ (contrainte de la fonction du lobe principal, en option), $\hat{H}$ est l'estimée de l'équation de la frontière du lobe principal.

* $G_r(\theta,\varphi) \geq 0$ (contrainte de gain positif).

* $PIRE_i$ = valeur de PIRE fixée.
Cette contrainte, consistant à figer la valeur de l'une des PIRES recherchées, permet de lever l'ambiguité entre lesdites PIREs et le gain dans l'axe de l'antenne de réception.

<u>REFERENCES</u>

[1] "Satellite Attitude From a Single GPS Antenna" de Y. Hashida et M.J. Unwin (Proceedings de l'Institute Of Navigation (I.O.N) GPS 93 Technical Meeting, pages 355-363)

[2] "Using GPS to Determine the Attitude of a Spacecraft" de M. Martin-Neira et R. Lucas (mars 1993, GPS world pages 49-54)

[3] "Use of Signal-To-Noise Ratio for Multipath Error Correction in GPS Differential Phase Measurements: Methodology and Experimental Results" de P. Axelrad, C. Comp et P. MacDoran (Proceedings de l'Institute Of Navigation (I.O.N.) GPS 94, pages 655-666)

[4] "Markets Proliferating for Global Positioning Systems" de D. M. Graham (mars 1990, "Sea Technology", pages 55-57)

[5] "Technical Description and Characteristics of Global Space Navigation System GLONASS-M" (International Telecommunication Union, Radiocommunication Study Groups, RTCA Papers, N° 502-94/SC159-594

[6] "Le GLONASS" de B. Panefieu (recueil de transparents d'une présentation faite par le Laboratoire de Recherche en Balistique en Aérodynamique (LRBA))

[7] "Accord de Standardisation ; caractéristiques du système mondial de détermination de la position NAVSTAR (GPS)" (OTAN, STANAG 4294)

[8] "Satellite-Antenna Measurement Techniques" de K.M. Keen, (IEEE Proc., volume 127, Pt. A., N° 7, septembre 1980, pages 417-434).

[9] "On-site earth station antenna verification" de Ernest P. Ekelman, et Steven M. Frimel (IEEE Antennas and Propagation Society International Symposium, volume 4, 20-24 juillet 1992, pages 2060-2063).

**Revendications**

1. Procédé de mesure du diagramme d'une antenne dans lequel :

   - on connecte l'antenne (30) à un récepteur (33) capable de fournir des mesures de C/No, qui est le rapport de la puissance de signal utile sur la densité spectrale de puissance de bruit, et éventuellement des mesures de variation de phase ;
   - on place l'antenne (30) au sommet d'un mât (32) ou d'un satellite porteur, orientée dans la direction du ciel pour suivre les satellites d'une constellation ; la bande de réception de l'antenne contenant la bande d'émission des antennes des satellites ;
   - on enregistre les rapports C/No associés aux satellites observables et éventuellement les variations de phase pendant une durée déterminée de façon automatique ;
   - on en déduit par calcul le diagramme de ladite antenne (30).

2. Procédé selon la revendication 1, caractérisé en ce qu'on calcule une fonction de gain de l'antenne en ajustant les mesures selon un critère des moindres carrés.

**3.** Procédé selon la revendication 1, caractérisé en ce que les satellites sont des satellites à défilement.

**4.** Procédé selon la revendication 1, caractérisé en ce que le gain de l'antenne s'exprime comme une série limitée de fonctions élémentaires fi de θ et φ paramétrées par les coefficients ai, bi, ci, di et ei :

$$G_r = \sum_{i=0}^{i=n} f_i(ai, bi, ci, di, ei, \theta, \varphi)$$

θ et φ étant des coordonnées sphériques.

**5.** Procédé selon la revendication 1, caractérisé en ce que l'antenne (30) est une antenne en bande L, S, C, VHF ou UHF.

**6.** Procédé selon la revendication 1, caractérisé en ce que la constellation de satellites est du type GPS, GLONASS, GN552 GLOBALSTAR, IRIDIUM, ORBCOMM, SATIVOD ou TELEDESIC.

## Claims

**1.** Process for measuring an antenna diagram, in which:

- the antenna (30) is connected to a receiver (33) capable of supplying measurements of C/No (which is the ratio of the useful signal power to the noise power spectral density) and possibly phase variation measurements;
- the antenna (30) is placed at the top of a mast (32) or on a carrier satellite facing the sky to track satellites in a constellation; the antenna reception band being included in the transmission band of the satellite antennas;
- the C/No ratios associated with observable satellites and optionally the phase variations are recorded automatically for a fixed period;
- the diagram of the said antenna (30) is determined by calculation.

**2.** Process according to claim 1, characterized in that an antenna gain function is calculated by adjusting the measures using a least squares criterion.

**3.** Process according to claim 1, characterized in that the satellites are nonsynchronous.

**4.** Process according to claim 1, characterized in that the antenna gain is given by the formula

$$G_r = \sum_{i=0}^{i=0} f_i\ (ai,\ bi,\ ci,\ di,\ ei,\ \theta,\phi)$$

where θ and ϕ are spherical coordinates.

**5.** Process according to claim 1, characterized in that the antenna (30) is an antenna in the L, S, C, VHF or UHF band.

**6.** Process according to claim 1, characterized in that the satellite constellation is of the GPS, GLONASS, GN552, GLOBALSTAR, IRIDIUM, ORBCOM, SATIVOD or TELEDESIC type.

## Patentansprüche

**1.** Verfahren zur Messung des Diagramms einer Antenne mit folgenden Schritten:

- man verbindet die Antenne (30) mit einem Empfänger (33), der fähig ist, Messungen von C/No, welches das Verhältnis der Leistung des Nutzsignals zur Geräusch-Spektralleistungsdichte ist, und eventuell Messungen der Phasenschwankung bzw. -änderung zu liefern;
- man platziert die Antenne (30) an der Spitze eines Masts (32) oder Trägersatelliten, in Richtung Himmel ausgerichtet, um die Satelliten einer Konstellation zu verfolgen, wobei das Empfangsband der Antenne das Sendeband der Antennen der Satelliten enthält;
- man zeichnet die den beobachtbaren Satelliten zugeordneten C/No-Verhältnisse und eventuell die Phasenschwankungen während einer bestimmten Dauer automatisch auf;
- man leitet davon durch Berechnung das Diagramm der genannten Antenne (30) ab.

**2.** Verfahren nach Anspruch 1, dadurch gekennzeichnet, dass man eine Antennenverstärkungsfunktion berechnet, indem man die Messungen nach einem Kriterium der kleinsten Fehierquadrate justiert bzw. anpasst.

**3.** Verfahren nach Anspruch 1, dadurch gekennzeichnet, dass die Satelliten Umlaufsatelliten sind.

**4.** Verfahren nach Anspruch 1, dadurch gekennzeichnet, dass die Antennenverstärkung ausgedrückt wird als eine begrenzte Serie Elementarfunktionen fi von θ und φ, parametriert durch die Koeffizienten ai, bi, ci, di und ei:

$$G_r = \sum_{i=0}^{i=n} f_i(ai, bi, ci, di, ei, \theta, \varphi)$$

wo θ und φ Kugelkoordinaten sind.

**5.** Verfahren nach Anspruch 1, dadurch gekennzeichnet, dass die Antenne (30) eine L-,S-,C-, VHF- oder UHF-Band-Antenne ist.

**6.** Verfahren nach Anspruch 1, dadurch gekennzeichnet, dass die Satellitenkonstellation vom Typ GPS, GLONASS, GNSS2, GLOBESTAR, IRIDIUM, ORBCOMM, SATIVOD oder TELEDESIC ist.

FIG. 1

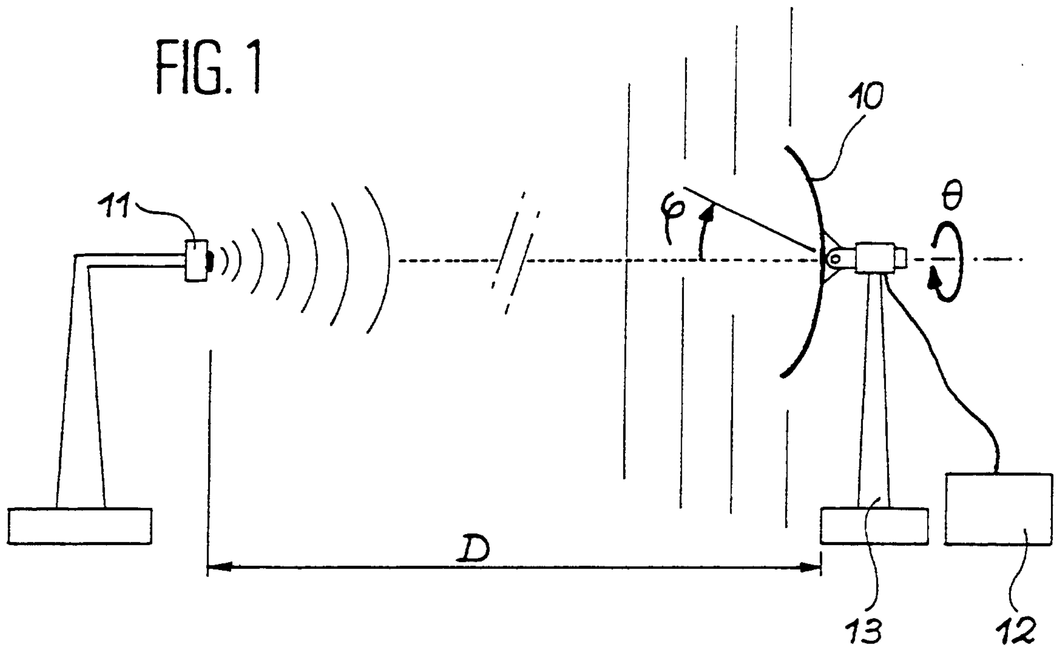


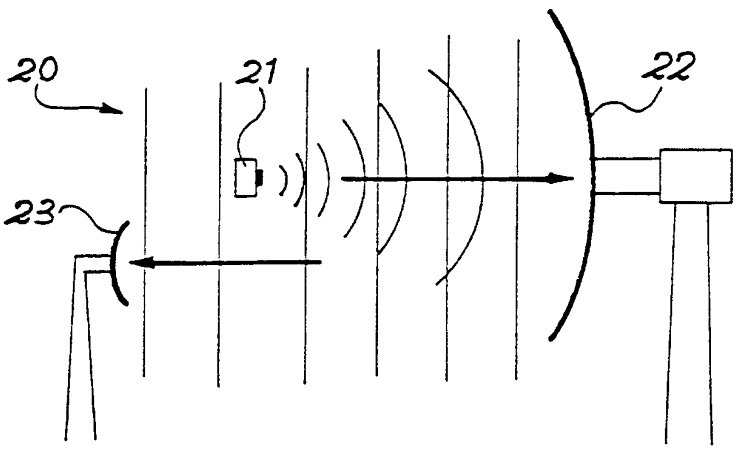


FIG. 2

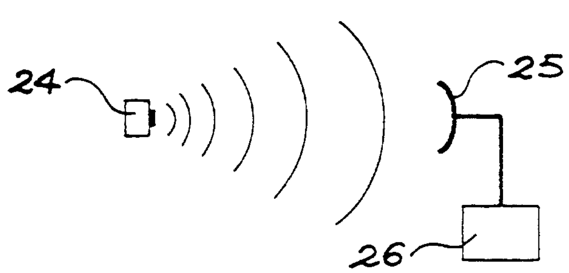


FIG. 3

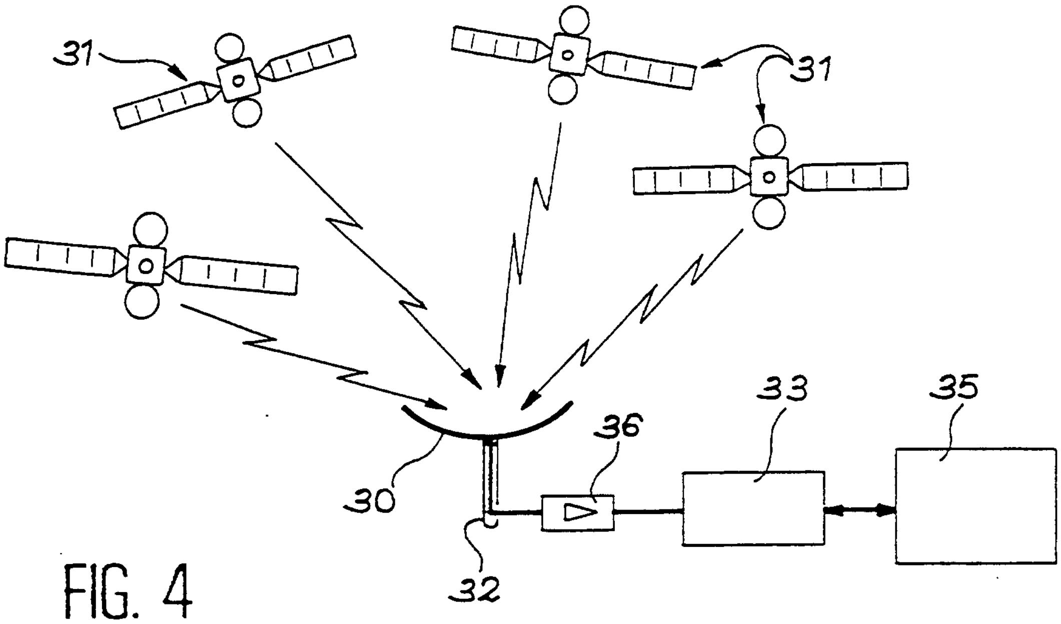


FIG. 4

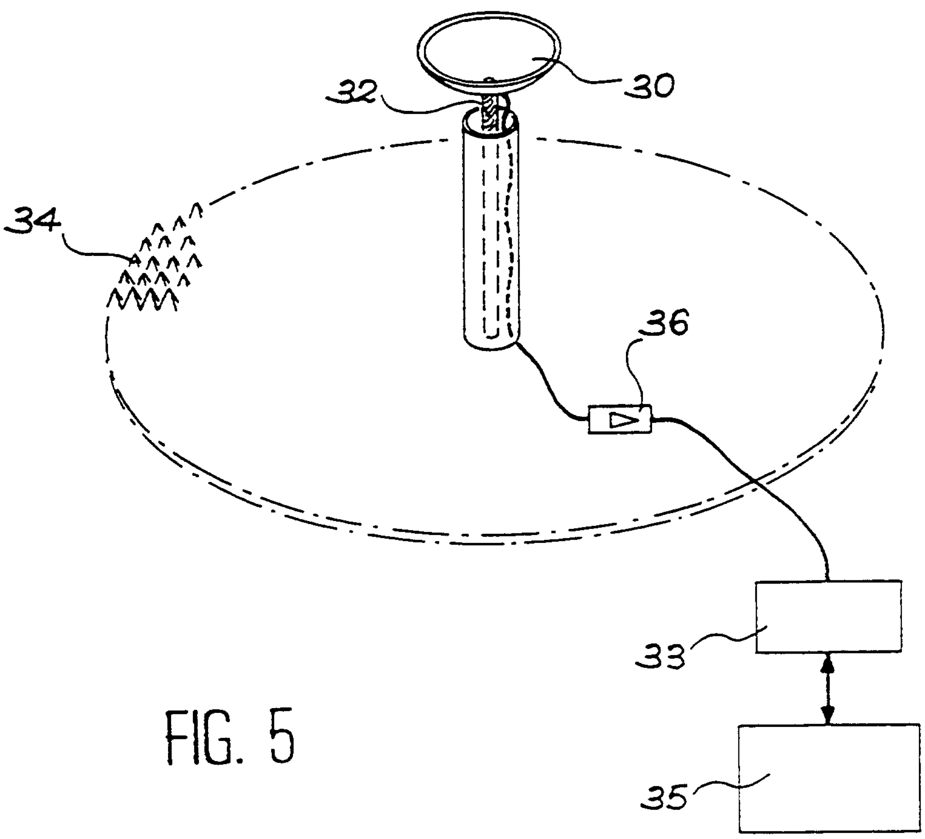


FIG. 5

FIG. 6

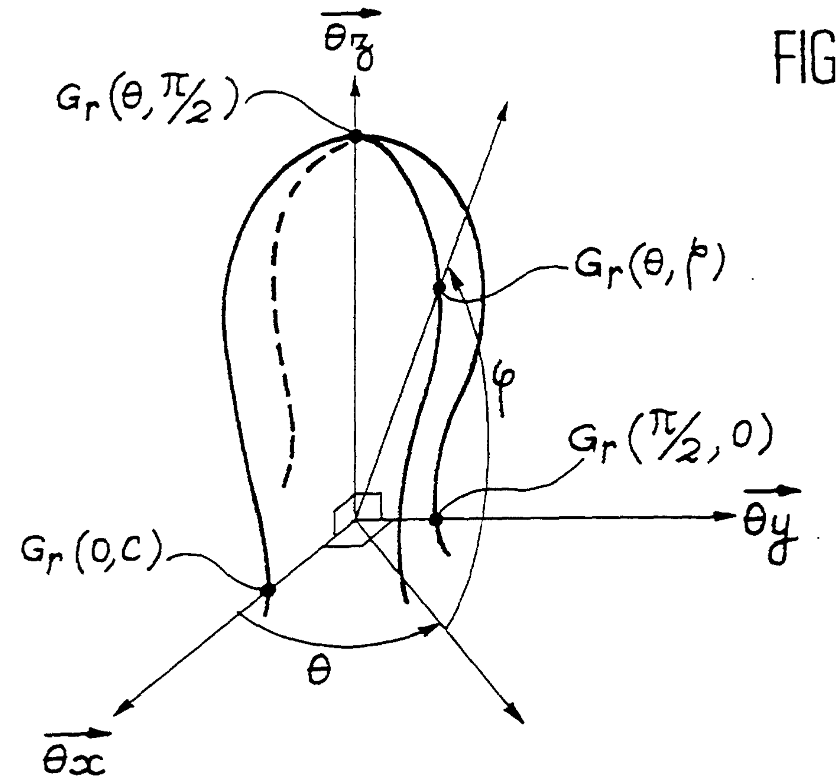
θz
Gr(θ, π/2)
Gr(θ, φ)
φ
Gr(π/2, 0)
θy
Gr(0,C)
θ
θx

FIG. 7

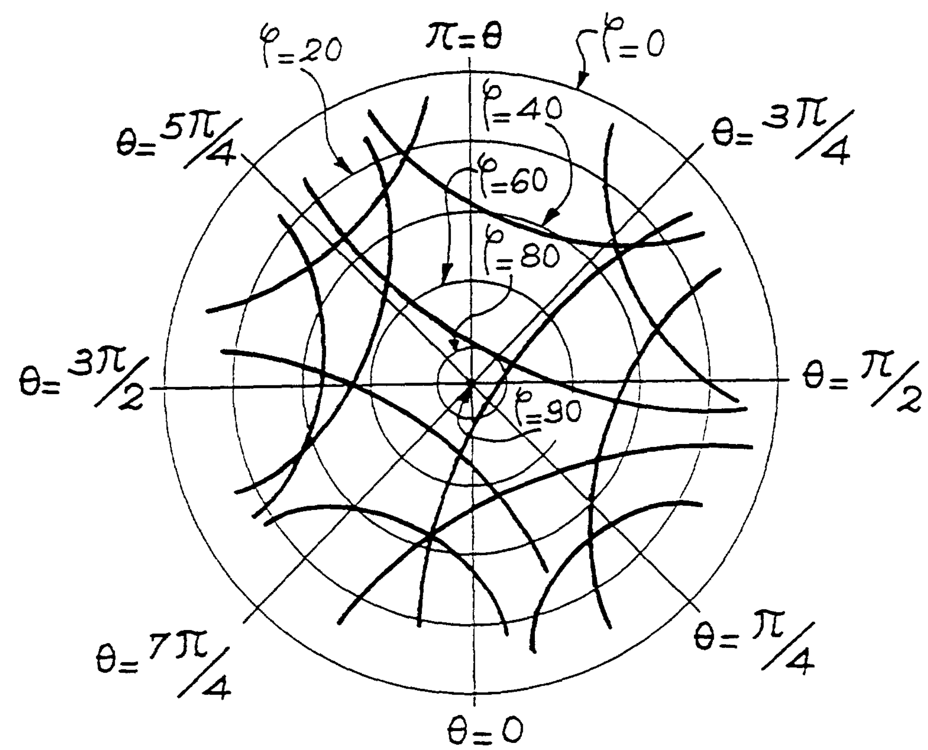
φ=20
π=θ
φ=0
φ=40
θ=5π/4
θ=3π/4
φ=60
φ=80
θ=3π/2
θ=π/2
φ=90
θ=7π/4
θ=π/4
θ=0

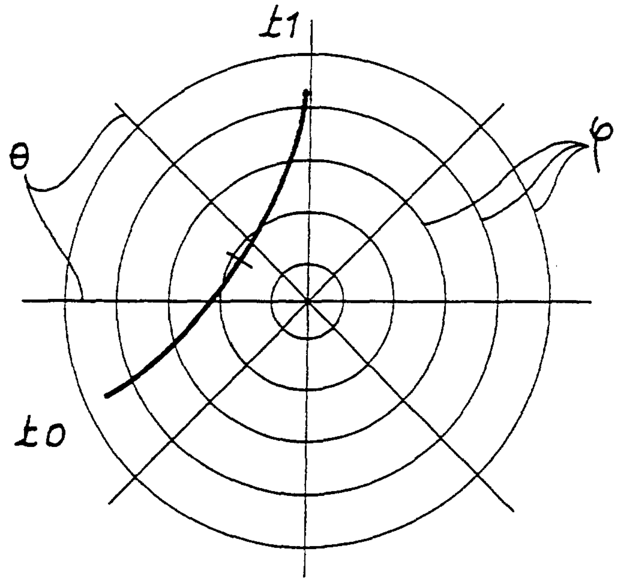


FIG. 8

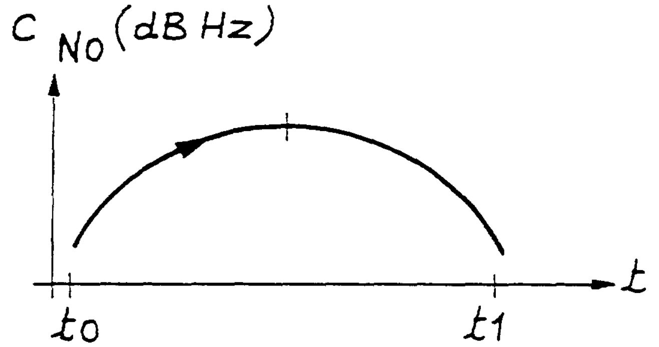


FIG. 9

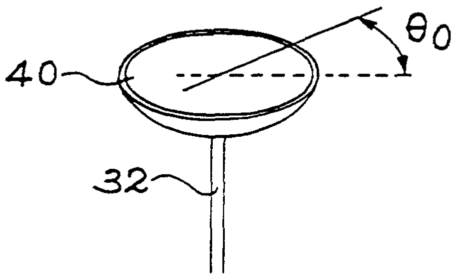


FIG. 11

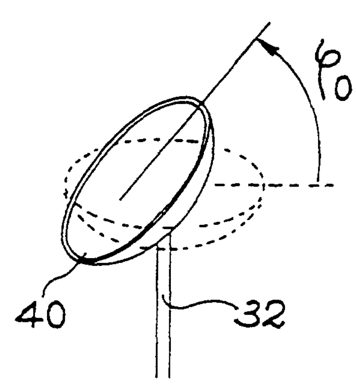


FIG. 12

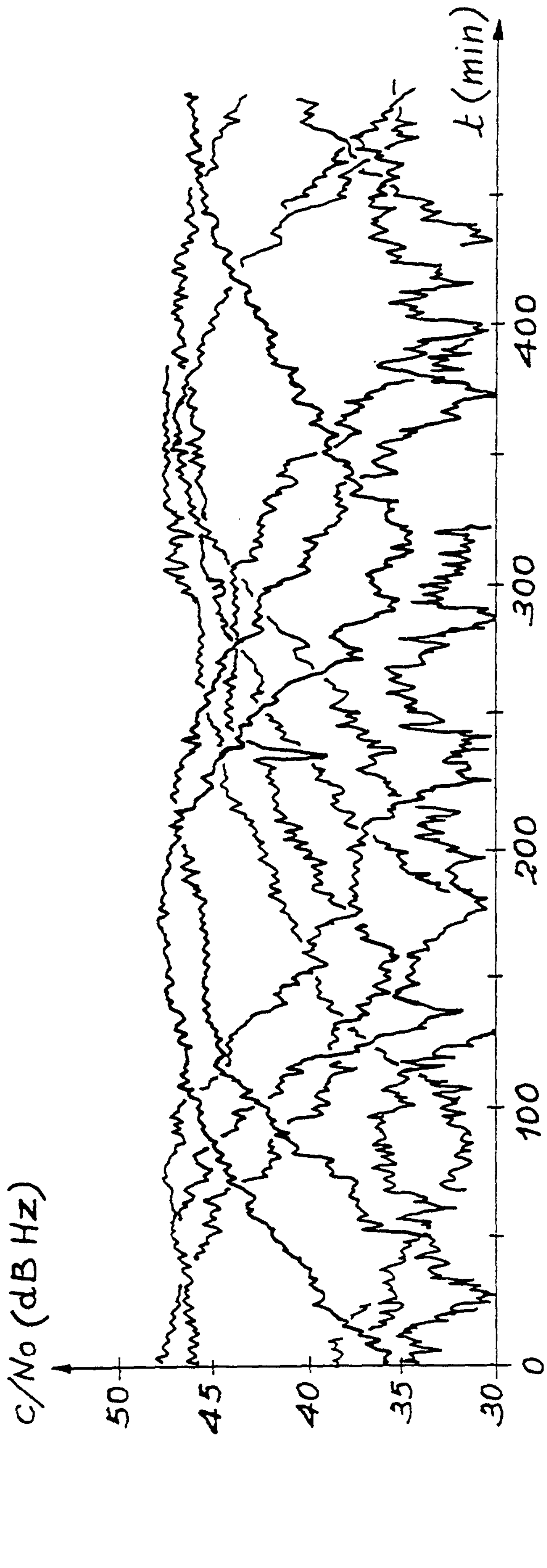


FIG. 10